# EUROPÄISCHE PATENTSCHRIFT

(11) **EP 2 831 911 B1**
(45) Veröffentlichungstag und Bekanntmachung des Hinweises auf die Patenterteilung: **24.08.2016**
(21) Anmeldenummer: 13707598.2
(22) Anmeldetag: 25.02.2013
(51) Int. Cl.: H01L 21/677

(54) **BEARBEITUNGSSTATION FÜR FLÄCHIGE SUBSTRATE UND VERFAHREN ZUM BEARBEITEN VON FLÄCHIGEN SUBSTRATEN**
PROCESSING STATION FOR PLANAR SUBSTRATES AND METHOD FOR PROCESSING PLANAR SUBSTRATES
STATION DE TRAITEMENT DE SUBSTRATS PLANS ET PROCÉDÉ DE TRAITEMENT DE SUBSTRATS PLANS

(30) Priorität: 30.03.2012 DE 102012205249
(43) Veröffentlichungstag der Anmeldung: 04.02.2015
(73) Patentinhaber: JRT Photovoltaics GmbH & Co. KG, 79364 Malterdingen (DE)
(72) Erfinder: REICHENBACH, Michael, 79183 Waldkirch (DE); BAU, Markus, 77791 Berghaupten (DE)
(74) Vertreter: Patentanwälte Ruff, Wilhelm, Beier, Dauster & Partner mbB
(86) Internationale Anmeldenummer: PCT/EP2013/053655
(87) Internationale Veröffentlichungsnummer: WO 2013/143795

(56) Entgegenhaltungen:
- WO-A1-2009/141319

## Beschreibung

Die Erfindung betrifft eine Bearbeitungsstation für flächige Substrate mit wenigstens zwei Bearbeitungseinheiten und wenigstens zwei parallel zueinander angeordneten Transportlinien für Substrate, wobei die beiden Bearbeitungseinheiten zwischen den beiden Transportlinien platziert sind, sowie Mitteln zum Bewegen der Substrate von den Transportlinien zu den Bearbeitungseinheiten und zurück. Die Erfindung betrifft auch ein Verfahren zum Bearbeiten von flächigen Substraten mit einer erfindungsgemäßen Bearbeitungsstation.

Aus der internationalen Offenlegungsschrift WO 2011/000442 A1 ist eine gattungsgemäße Bearbeitungsstation für flächige Substrate bekannt, die als Siebdruckbearbeitungsstation ausgebildet ist. Unbearbeitete Substrate, speziell unbedruckte Solarzellenwafer, werden von den Transportlinien auf Drucknester übergeben, die dann auf einem Planartisch zu einer von zwei Siebdruckstationen bewegt werden. Nach dem Bedrucken der Solarzellenwafer werden die Drucknester wieder zu ihrem Ausgangspunkt verfahren und die bedruckten Solarzellenwafer werden wieder auf die Transportlinien übergeben.

Aus der internationalen Offenlegungsschrift WO 2009/141319 A1 ist eine im Wesentlichen gleichartige Siebdruckstation für Solarzellenwafer bekannt, bei der insgesamt vier Drucknester auf einem Rundschalttisch angeordnet sind. Mittels des Rundschalttisches werden die Solarzellenwafer auf den jeweiligen Drucknestern zu den Siebdruckstationen und wieder zu den Transportlinien bewegt. Die Transportlinien sind im Bereich von Übergabestellen auf die Drucknester mit Hubbändern versehen, um die Bewegungsbahn der Drucknester freizuhalten und die Drucknester an die jeweilige Übergabestelle bewegen zu können. Die Solarzellenwafer können auch in einer sogenannten Cross-Flow-Konfiguration bearbeitet werden, indem sie von der ersten Transportlinie auf das Drucknest übergeben werden, das Drucknest nach dem Bedrucken der Solarzellenwafer dann zu der zweiten Transportlinie bewegt wird und die bedruckten Solarzellenwafer dann mittels der zweiten Transportlinie abtransportiert werden.

Mit der Erfindung soll eine Bearbeitungsstation für flächige Substrate und ein Verfahren zum Bearbeiten flächiger Substrate verbessert werden.

Erfindungsgemäß ist hierzu eine Bearbeitungsstation für flächige Substrate mit wenigstens zwei Bearbeitungseinheiten und wenigstens zwei zueinander parallel angeordneten Transportlinien für Substrate vorgesehen, wobei die beiden Bearbeitungseinheiten zwischen den beiden Transportlinien platziert sind und wobei Mittel zum Bewegen der Substrate von den Transportlinien zu den Bearbeitungseinheiten und zurück vorgesehen sind, bei der die Mittel zum Bewegen der Substrate vier Lineartransporteinheiten mit jeweils wenigstens einer Substratauflage aufweisen, wobei eine erste Lineartransporteinheit zwischen der zweiten Transportlinie und der ersten Bearbeitungseinheit angeordnet ist, eine zweite Lineartransporteinheit zwischen der ersten Transportlinie und der ersten Bearbeitungseinheit angeordnet ist, eine dritte Lineartransporteinheit zwischen der ersten Transportlinie und der zweiten Bearbeitungseinheit angeordnet ist und eine vierte Lineartransporteinheit zwischen der zweiten Transportlinie und der zweiten Bearbeitungseinheit angeordnet ist.

Der Einsatz von Lineartransporteinheiten vereinfacht den konstruktiven Aufbau und ermöglicht einen Betrieb mit hoher Geschwindigkeit und dadurch großem Durchsatz, einen energiesparenden Betrieb und eine sehr hohe Präzision bei der Positionierung der Substratauflagen im Bereich der Bearbeitungseinheiten. Gerade beim Bedrucken von Solarzellen ist eine solche Positioniergenauigkeit von entscheidender Bedeutung, da die Kontaktfinger in der Regel sehr dünn sind und gegebenenfalls nur Bruchteile von Millimetern breit sind. Vor allem ist die Positioniergenauigkeit von entscheidender Bedeutung, wenn die Kontaktfinger auf den Solarzellen mehrschichtig aufgedruckt werden. Ein geringer Versatz von nur Bruchteilen von Millimetern kann bereits dazu führen, dass die zweite Schicht nicht exakt auf der ersten Schicht, sondern daneben aufgedruckt wird und die Solarzelle dadurch im Wesentlichen unbrauchbar wird. Die erfindungsgemäß vorgesehenen Lineartransporteinheiten ermöglichen es, eine hoch präzise Bearbeitungsstation bereitzustellen.

In Weiterbildung der Erfindung sind die erste und die vierte Lineartransporteinheit ausgebildet, die jeweilige Substratauflage an eine gemeinsame Übergabestelle im Bereich der zweiten Transportlinie zu bewegen. In Weiterbildung der Erfindung sind die zweite und die dritte Lineartransporteinheit ausgebildet, die jeweilige Substratauflage an eine gemeinsame Übergabestelle im Bereich der ersten Transportlinie zu bewegen.

Auf diese Weise können jeweils zwei Lineartransporteinheiten die Substrate an einer gemeinsamen Übergabestelle von einer Transportlinie übernehmen bzw. an diese übergeben. Obwohl zwei Bearbeitungseinheiten und vier Lineartransporteinheiten vorgesehen sind, wird in jeder Transportlinie damit lediglich eine Übergabestelle benötigt. Die Übergabestellen können beispielsweise mit Kameras oder sonstigen Mess- und Überprüfeinrichtungen ausgerüstet sein, um die Unversehrtheit der unbedruckten Solarzellen und deren Position zu erfassen sowie auch bei den bedruckten Solarzellen die korrekte Positionierung des Druckes sowie die Unversehrtheit der bedruckten Solarzellen zu überprüfen. Indem pro Transportlinie lediglich eine einzige Übergabestelle erforderlich ist, kann somit der konstruktive Aufwand für solche Mess- und Prüfstationen gering gehalten werden.

In Weiterbildung der Erfindung sind die beiden Bearbeitungseinheiten in Transportrichtung der Transportlinien voneinander beabstandet angeordnet und die vier Lineartransporteinheiten bilden in der Draufsicht eine rautenartige Anordnung.

Mittels einer rautenartigen Anordnung können zwei Bearbeitungsstationen mit zwei Übergabestellen verbunden werden und die jeweiligen Strecken zwischen den Bearbeitungseinheiten und den Übergabestellen können gleich lang gehalten werden. Als rautenartige Anordnung wird auch eine Anordnung der Lineartransporteinheiten in Form eines Quadrats angesehen.

In Weiterbildung der Erfindung sind die Lineartransporteinheiten als Linearführungen mit darauf geführtem Schlitten, sogenannte Linearachsen, ausgebildet.

Mittels solcher Linearachsen lässt sich eine schnelle Linearbewegung der Substratauflagen erzielen, wobei gleichzeitig eine hohe Positioniergenauigkeit möglich ist. Ein Antrieb der Linearachsen kann elektrisch, pneumatisch oder auch hydraulisch erfolgen.

In Weiterbildung der Erfindung sind die erste und die zweite Transportlinie im Bereich der jeweiligen Übergabestelle an die Lineartransporteinheiten abschnittsweise aus einer Bewegungsbahn der Substratauflagen der Lineartransporteinheiten heraus bewegbar.

Auf diese Weise kann ein Zwischenraum zwischen den Transportlinien und der jeweiligen Substratauflage, auf die ein Wafer übergeben werden soll oder von der ein Wafer übernommen werden soll, sehr klein gehalten werden und beispielsweise können die Solarzellenwafer mittels Transportbändern übergeben werden. Dies macht das Angreifen der Solarzellenwafer mittels Handlingvorrichtungen entbehrlich und minimiert dadurch das Risiko einer Beschädigung der Solarzellenwafer im unbedruckten und speziell auch im bedruckten Zustand. Indem ein Zwischenraum zwischen den Transportlinien und der jeweiligen Substratauflage klein gehalten wird, kann auch eine hohe Positioniergenauigkeit bei der Übergabe bzw. Übernahme der Solarzellenwafer realisiert werden.

In Weiterbildung der Erfindung weisen die erste und die zweite Transportlinie im Bereich der jeweiligen Übergabestelle Hubbänder, Klappbänder, Schwenkbänder und/oder Teleskopbänder auf.

Mittels solcher Einrichtungen können die Transportlinien abschnittsweise aus einer Bewegungsbahn der Substratauflagen heraus bewegt werden und dennoch können die Substrate mittels Bandtransporteinrichtungen und damit ohne Handlingvorrichtungen, die an den Wafern mittels Greifarmen oder sonstigem angreifen, übergeben bzw. übernommen werden.

In Weiterbildung der Erfindung sind die Bearbeitungseinheiten als Siebdruckstationen und die Substratauflagen als Drucknester ausgebildet.

Vorteilhafterweise sind die Substratauflagen mit einem über die Auflagefläche führenden Endlosband versehen.

Mittels eines solchen Endlosbandes kann die Übernahme von Substraten auf die jeweilige Substratauflage und das Übergeben von Substraten von der Substratauflage auf das jeweilige Transportband erfolgen. Alternativ zu einem Endlosband kann ein vor- und zurückspulbares Band, beispielsweise ein Papierband, vorgesehen sein.

In Weiterbildung der Erfindung ist das Endlosband durchleuchtbar und/oder durchsaugbar ausgebildet.

Bei einer durchleuchtbaren Endlosband kann eine Lichtquelle beispielsweise unterhalb des Endlosbandes angeordnet werden und eine Kamera kann dann auf der gegenüberliegenden Seite des Endlosbandes angeordnet werden oder umgekehrt. Als durchleuchtbar wird auch eine Durchlässigkeit für allgemein elektromagnetische Strahlung bezeichnet. Eine durchsaugbare Ausgestaltung des Endlosbandes erlaubt es, das zu bearbeitende Substrat mittels Unterdruck auf der Substratauflage festzuhalten. Umgekehrt ermöglicht eine durchsaugbare Ausgestaltung des Endlosbandes auch, das Substrat beispielsweise mittels eines Luftstroms wenigstens abschnittsweise von dem Endlosband abzuheben und beispielsweise abzutransportieren.

Das der Erfindung zugrundeliegende Problem wird auch durch ein Verfahren zum Bearbeiten von flächigen Substraten mit einer erfindungsgemäßen Bearbeitungsstation gelöst, wobei das Bewegen von unbearbeiteten Substraten mittels einer der Lineartransporteinheiten von einer der Transportlinien zu einer Bearbeitungseinheit und der Rücktransport des bearbeiteten Substrats von der Bearbeitungseinheit zu derselben Transportlinie mittels derselben Lineartransporteinheit vorgesehen ist.

Mittels der jeweiligen Lineartransporteinheit kann dadurch ein Pendelbetrieb realisiert werden, mit dem ein unbearbeitetes Substrat von einer Transportlinie übernommen wird, zu der Bearbeitungseinheit transportiert wird und nach der Bearbeitungseinheit wieder zurück zu derselben Transportlinie transportiert und wieder auf diese übergeben wird. Da die Transportlinie bearbeitete und unbearbeitete Substrate in der gleichen Richtung weiter transportiert, werden die unbearbeiteten Substrate in der gleichen Richtung auf die Substratauflage übergeben in der sie dann auch von der Substratauflage wieder auf die Transportlinie übernommen werden.

In Weiterbildung der Erfindung sind folgende, im Wesentlichen gleichzeitige Transportbewegungen vorgesehen:
- Bewegen eines ersten Substrats mittels der ersten Lineartransporteinheit von der zweiten Transportlinie zu der ersten Bearbeitungseinheit und
- Bewegen eines zweiten Substrats mittels der zweiten Lineartransporteinheit von der ersten Bearbeitungseinheit zu der ersten Transportlinie.

Auf diese Weise kann ein erstes, noch unbearbeitetes Substrat zu der ersten Bearbeitungseinheit bewegt werden und im Wesentlichen gleichzeitig wird ein zweites, bereits bearbeitetes Substrat von der ersten Bearbeitungseinheit abtransportiert. Auf diese Weise kann eine sehr geringe Taktzeit beim Bearbeiten von Substraten, insbesondere beim Bedrucken von Solarzellen, erzielt werden.

In Weiterbildung der Erfindung sind folgende, im Wesentlichen gleichzeitig Transportbewegungen vorgesehen:
- Bewegen eines dritten Substrats mittels der dritten Lineartransporteinheit von der ersten Transportlinie zu der zweiten Bearbeitungseinheit und
- Bewegen eines vierten Substrats mittels der vierten Lineartransporteinheit von der zweiten Bearbeitungseinheit zu der zweiten Transportlinie.

Auf diese Weise können zwei Bearbeitungseinheiten mittels der vier Lineartransporteinheiten mit hoher Taktzeit beaufschlagt werden. Der Antransport von unbearbeiteten Substraten und der Abtransport von bereits bearbeiteten Substraten erfolgt über die beiden _Transportlinien. Eine solche Anordnung mit zwei Bearbeitungseinheiten, vier Lineartransporteinheiten und zwei Transportlinien hat den Vorteil, auch bei Ausfall oder Wartung einer der Bearbeitungseinheiten noch weiter betrieben werden zu können, wenn auch mit verringerter Kapazität. Ein wesentlicher Vorteil dabei ist, dass beide Transportlinien weiterhin bearbeitete Substrate abtransportieren können, so dass stromabwärts der Bearbeitungsstation gelegene weitere Bearbeitungsstationen weiter arbeiten können, wenn auch mit verringerter Kapazität. Die Wartung, Reparatur oder Umrüstung der Bearbeitungsstationen, beispielsweise beim Siebwechsel einer Siebdruckstation, ist dadurch im laufenden Betrieb möglich, ohne dass eine Fertigungslinie vollständig angehalten werden muss.

In Weiterbildung der Erfindung ist das Übergeben von Substraten von den Transportlinien auf die Substratauflagen der Lineartransporteinheiten und umgekehrt das Übernehmen von Substraten von den Substratauflagen auf die Transportlinien im Bereich von Übergabestellen vorgesehen, sowie das abschnittsweise Bewegen der Transportlinien im Bereich der Übergabestellen zum Freigeben einer Bewegungsbahn der Substratauflagen.

Indem die Transportlinien im Bereich der Übergabestellen bewegt werden und eine Bewegungsbahn der Substratauflagen zeitweise freigeben, kann ein sehr geringer Zwischenraum bei der Übergabe bzw. Übernahme von Substraten zwischen Transportlinie und Substratauflage realisiert werden. Eine Übergabe der Substrate ist dadurch beispielsweise mittels Bandtransport möglich.

In Weiterbildung der Erfindung werden im Bereich der Übergabestellen Hubbänder, Klappbänder, Schwenkbänder und/oder Teleskopbänder der Transportlinien zum Freigeben der Bewegungsbahn der Substratauflagen bewegt.

Auf diese Weise kann eine Bewegungsbahn der Substratauflagen zeitweise freigegeben werden und dennoch kann eine schnelle, materialschonende und positionsgenaue Übergabe bzw. Übernahme der Substrate realisiert werden.

Weitere Merkmale und Vorteile der Erfindung ergeben sich aus den Ansprüchen und der nachfolgenden Beschreibung einer bevorzugten Ausführungsform der Erfindung im Zusammenhang mit den Zeichnungen. In den Zeichnungen zeigen:
- Fig. 1: eine schematische Draufsicht auf eine erfindungsgemäße Bearbeitungsstation für flächige Substrate, die als Siebdruckstation ausgebildet ist,
- Fig. 2: eine schematische Seitenansicht einer Substratauflage, die als Drucknest ausgebildet ist, aus der Bearbeitungsstation der Fig. 1, und
- Fig. 3: eine weitere schematische Ansicht einer als Drucknest ausgebildeten Substratauflage aus der Bearbeitungsstation der Fig. 1.

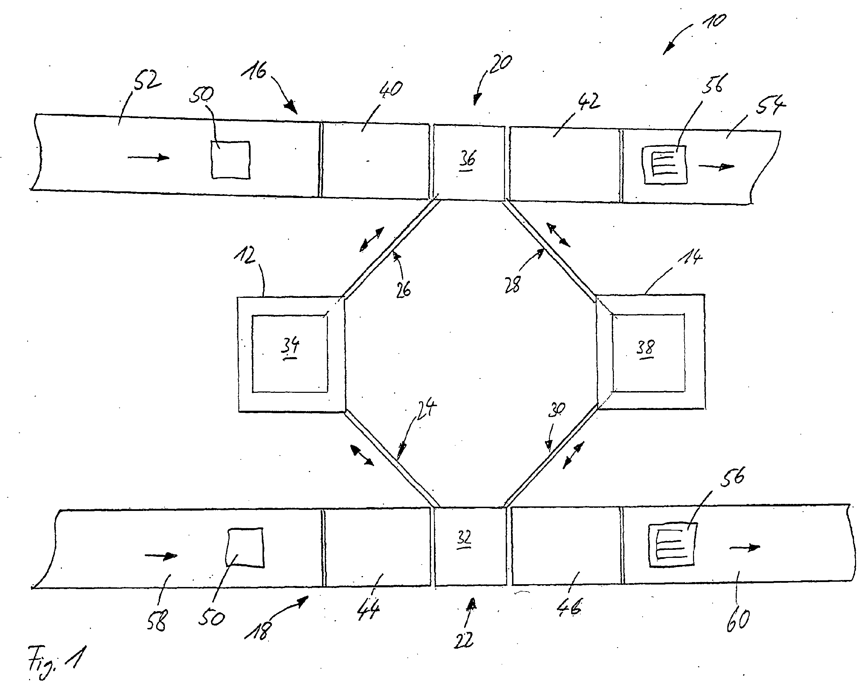

Die Darstellung der Fig. 1 zeigt eine Bearbeitungsstation 10 für flächige Substrate, im dargestellten Fall eine Siebdruckstation zum Bedrucken von Solarzellenwafern. Die Bearbeitungsstation 10 weist zwei Bearbeitungseinheiten 12, 14 in Form von Druckwerken zum Siebdrucken auf. Zwei parallel zueinander angeordnete Transportlinien 16, 18 transportieren unbearbeitete Substrate, nämlich unbedruckte Solarzellenwafer, zu Übergabestellen 20 bzw. 22 in den Transportlinien 16, 18 und transportieren die dann bearbeiteten Substrate, nämlich die bedruckten Solarzellenwafer, dann wieder von den Übergabestellen 20, 22 ab.

Die Bearbeitungsstation 10 weist vier Lineartransporteinheiten 24, 26, 28 und 30 auf. Jede dieser Lineartransporteinheiten 24, 26, 28, 30 weist jeweils eine Substratauflage 32, 34, 36, 38 auf, die jeweils als Drucknester ausgebildet sind. Mittels der ersten Lineartransporteinheit 24 kann die Substratauflage 32 von der Übergabestelle 22 in der zweiten Transportlinie 18 zu der ersten Bearbeitungseinheit 12 und wieder zurückbewegt werden. Mittels der zweiten Lineartransporteinheit 26 kann die Substratauflage 34 von der ersten Bearbeitungseinheit 12 zu der Übergabestelle 20 in der ersten Transportlinie 16 und wieder zurückbewegt werden. Mit der dritten Lineartransporteinheit 28 kann die Substratauflage 36 von der Übergabestelle 20 in der ersten Transportlinie 16 zur zweiten Bearbeitungseinheit 14 und wieder zurückbewegt werden. Mittels der vierten Lineartransporteinheit 30 kann die Substratauflage 38 von der zweiten Bearbeitungseinheit 14 zu der Übergabestelle 22 in der zweiten Transportlinie 18 und wieder zurück bewegt werden. Diese Bewegungen der Substratauflagen 32, 34, 36, 38 sind jeweils mittels eines Doppelpfeils angedeutet. Die Lineartransporteinheiten 24, 26, 28, 30 sind jeweils als sogenannte Linearachsen ausgebildet, weisen also Linearführungen mit darauf angeordneten Schlitten und einen Antrieb für die Schlitten auf, beispielsweise einen elektromotorischen Antrieb mittels eines Linearmotors, einen Spindelantrieb oder auch einen hydraulischen oder pneumatischen Antrieb. Mittels solcher Linearachsen kann eine schnelle und dabei hoch präzise Bewegung der Substratauflagen 32, 34, 36, 38 erfolgen, die jeweils auf dem Schlitten der Linearachsen angebracht sind.

In Transportrichtung gesehen vor und hinter der jeweiligen Übergabestelle 20, 22 sind die erste Transportlinie 16 und die zweite Transportlinie 18 jeweils mit einem Hubband 40, 42, 44, 46 versehen. Unbearbeitete Solarzellenwafer 50 werden auf einem ersten Abschnitt 52 der ersten Transportlinie 16 in der Darstellung der Fig. 1 nach rechts transportiert und gelangen auf das Hubband 40. Von dem Hubband 40 wird der unbearbeitete Solarzellenwafer 50 dann auf die Substratauflage 36 übergeben, die mit einem über die Substratauflagefläche geführten Endlosband versehen ist. Sobald der Solarzellenwafer 50 auf der Substratauflage 36 angeordnet ist, wird diese mittels der dritten Lineartransporteinheit 28 in Richtung auf die zweite Bearbeitungseinheit 14 verfahren, bis die Substratauflage 36 unterhalb der Bearbeitungseinheit 14 angeordnet ist. In dieser Position kann der Solarzellenwafer 50 mit dem Siebdruckwerk der Bearbeitungseinheit 14 dann bedruckt werden.

Um die Substratauflage 36 aus ihrer in Fig. 1 dargestellten Position in der Transportlinie 16 herauszubewegen, muss das stromabwärts der Substratauflage 36 angeordnete Hubband 42 abgesenkt oder angehoben werden, um das Hubband 42 aus dem Bewegungsbereich der Substratauflage 36 herauszufahren. Sobald die Substratauflage 36 sich ein Stück weit in Richtung auf die zweite Bearbeitungseinheit 14 zu bewegt hat, kann das Hubband 42 wieder in seine ursprüngliche Position verfahren werden. Im Wesentlichen gleichzeitig muss das Hubband 40 angehoben oder abgesenkt werden, um aus dem Bewegungsbereich der Substratauflage 34 herausbewegt zu werden, die mittels der zweiten Lineartransporteinheit 26 aus ihrer in Fig. 1 dargestellten Position in der Bearbeitungseinheit 12 in Richtung auf die Übergabestelle 20 bewegt wird. Sobald die Substratauflage 34 an der Übergabestelle 20 angelangt ist, kann der auf der Substratauflage 34 befindliche bedruckte Solarzellenwafer 50 auf das Hubband 42 übergeben werden und wird dann mittels der Transportlinie 16 in der Fig. 1 nach rechts auf einem Abschnitt 54 der ersten Transportlinie 16 abtransportiert.

Die zweite Lineartransporteinheit 26 und die dritte Lineartransporteinheit 28 bzw. die zugeordneten Substratauflagen 34, 36 führen somit eine Pendelbewegung aus. Während ein unbedruckter Solarzellenwafer auf die Substratauflage 36 übergeben wird, befindet sich die Substratauflage 34 in der Bearbeitungseinheit 12 und der Solarzellenwafer wird bedruckt. Wenn sich die Substratauflage 36 in der zweiten Bearbeitungseinheit 14 befindet, ist die Substratauflage 34 an der Übergabestelle 20 angeordnet und der bedruckte Solarzellenwafer wird abtransportiert.

In analoger Weise werden unbedruckte Solarzellenwafer 50 auf der zweiten Transportlinie 18 von dem ersten Abschnitt 58 auf das Hubband 44 übergeben und von dort aus dann auf die Substratauflage 32 bewegt. Sobald sich der unbedruckte Solarzellenwafer 50 auf der Substratauflage 32 befindet, wird das Hubband 44 angehoben oder abgesenkt, um die Bewegungsbahn der Substratauflage 32 freizugeben. Die Substratauflage 32 mit dem darauf angeordneten unbearbeiteten Solarzellenwafer 50 kann dann mittels der Lineartransporteinheit 24 zu der ersten Bearbeitungseinheit 12 bewegt, um den Solarzellenwafer zu bedrucken. Gleichzeitig mit der Bewegung der Substratauflage 32 in Richtung auf die erste Bearbeitungseinheit 12 zu, wird die Substratauflage 34 aus der ersten Bearbeitungseinheit 12 heraus und in Richtung auf die Übergabestelle 20 bewegt, um den bedruckten Solarzellenwafer wieder auf die Transportlinie 16 zu übergeben.

Gleichzeitig mit der Bewegung der Substratauflage 32 von der Übergabestelle 22 weg in Richtung auf die erste Bearbeitungseinheit 12 wird die Substratauflage 38 mit einem darauf angeordneten bedruckten Solarzellenwafer von ihrer Position in der zweiten Bearbeitungseinheit 14 in Richtung auf die Übergabestelle 22 in der zweiten Transportlinie 18 bewegt. Um den Bewegungsbereich der Substratauflage 38 freizugeben, wird das stromabwärts der Übergabestelle 22 angeordnete Hubband 46 angehoben oder abgesenkt, bis die Substratauflage 38 an der Übergabestelle 22 angelangt ist. Das Hubband 46 wird dann auf Höhe der Substratauflage 38 gebracht, und der bedruckte Solarzellenwafer auf der Substratauflage 38 kann auf das Hubband 46 übernommen werden und von diesem dann auf den zweiten Abschnitt 60 der zweiten Transportlinie 18 übergeben und abtransportiert werden. Noch während sich die Substratauflage 38 an der Übergabestelle 22 befindet, wird ein weiterer, unbedruckter Solarzellenwafer 50 mittels des Hubbands 44 auf die Substratauflage 38 übergeben und dann, nachdem das Hubband 46 aus dem Bewegungsbereich der Substratauflage 38 heraus bewegt worden ist, wieder in die in Fig. 1 dargestellte Position in der zweiten Bearbeitungseinheit 14 bewegt.

Die Substratauflagen 32, 38 werden somit dann, wenn sie an der Übergabestelle 22 angeordnet sind, zunächst entladen, indem ein bedruckter Solarzellenwafer in der Fig. 1 nach rechts abtransportiert wird. Gleichzeitig werden die Substratauflagen 32, 38 an der Übergabestelle 22 wieder mit einem unbedruckten Solarzellenwafer 50 beladen, der in der Fig. 1 von links antransportiert wird.

In analoger Weise werden die Substratauflagen 34, 36 an der Übergabestelle 20 in der ersten Transportlinie 16 gleichzeitig entladen und wieder beladen.

Im Bereich der Übergabestellen 20, 22 sind Mess- und Überprüfungsstationen angeordnet, die mit Kameras und Bildverarbeitung versehen sind. Vor dem Bedrucken und nach dem Bedrucken können die Solarzellenwafer 50, 56 somit auf Beschädigungen, korrekte Positionierung auf den Substratauflagen sowie auch auf eine korrekte Positionierung und Ausführung der aufgedruckten Kontakte überprüft werden.

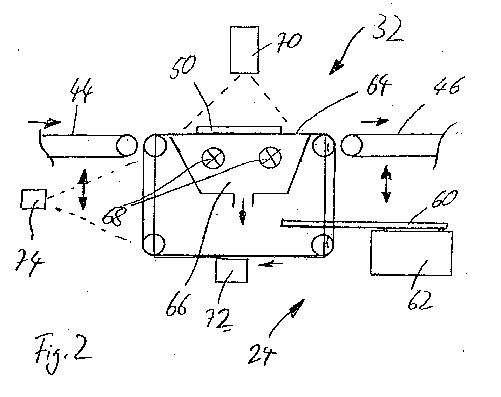

Die Darstellung der Fig. 2 zeigt schematisch die Substratauflage 32, die als Drucknest ausgebildet ist, in einer Seitenansicht. Die Substratauflage 32 ist an einem Schlitten 60 angeordnet, der wiederum an einer Linearführung 62 längsverschiebbar geführt ist. Die Linearführung 62, der Schlitten 60 und die Substratauflage 32 sowie ein nicht dargestellter Antrieb für den Schlitten 60 bilden die Lineartransporteinheit 24. Die Lineartransporteinheiten 26, 28, 30 sind im Wesentlichen identisch hierzu aufgebaut.

Die Substratauflage 32 weist ein über ihre in Fig. 2 obere Auflagefläche geführtes Endlosband 64 auf, auf dem dann ein Solarzellenwafer 50 aufliegt und mit dem der Solarzellenwafer 50 auf das Drucknest übernommen und wieder von diesem abtransportiert werden kann. Das Endlosband bewegt sich in der Darstellung der Fig. 2 dabei immer im Uhrzeigersinn. Das Endlosband 64 ist durchleuchtbar und durchsaugbar ausgebildet. Die Substratauflage 32 ist mit einer Absaugeinrichtung 66 versehen, über die an der Unterseite des Solarzellenwafers 50 ein Unterdruck angelegt werden kann. Der Solarzellenwafer 50 kann dadurch unverrückbar auf der Substratauflage 32 festgehalten werden. Während des Transports der Substratauflage 32 und auch während des Bedruckens des Solarzellenwafers 50 kann der Solarzellenwafer 50 dadurch nicht relativ zur Substratauflage 32 verrutschen.

Das Endlosband 64 ist darüber hinaus durchleuchtbar ausgebildet. Innerhalb der Substratauflage 32 ist wenigstens eine Lichtquelle 68 oder allgemein eine elektromagnetische Strahlungsquelle angeordnet, die den Solarzellenwafer 50 von unten her beleuchten. Eine Überprüfungskamera 70, allgemein ein Strahlungssensor, ist oberhalb der Substratauflage 32 angeordnet und dient zum Überprüfen des Solarzellenwafers 50 im unbedruckten Zustand, zum Überprüfen einer Position des Solarzellenwafers 50 auf der Substratauflage 32, zu einer Überprüfung des Druckbildes auf dem dann bedruckten Solarzellenwafer, zum Überprüfen eines Bruchs des Solarzellenwafers innerhalb des Wafers sowie auch an der Außenseite und zu einer Überprüfung der Kontur des Solarzellenwafers Die Überprüfungen mit der Überprüfungskamera können im Auflicht oder Durchlicht, allgemein mittels elektromagnetischer Strahlung erfolgen.Die Kamera 70 kann stationär im Bereich der Übergabestellen 20, 22 angeordnet sein, wird also nicht zusammen mit der Substratauflage 32 bewegt.

In der Fig. 2 sind schematisch noch die Hubbänder 44, 46 angedeutet. Wie bereits beschrieben wurde, kann mittels des Hubbands 44 der Solarzellenwafer 50 auf die Substratauflage 32 übergeben werden, wobei das Endlosband 64 bei der Übergabe im Uhrzeigersinn umläuft und den Solarzellenwafer 50 übernimmt. Nach dem Bedrucken kann der Solarzellenwafer 50 dann von dem Hubband 46 übernommen werden, wobei für diese Übergabe das Endlosband 64 ebenfalls in Bewegung gesetzt wird, in der Darstellung der Fig. 2 im Uhrzeigersinn. Wird die Substratauflage 32, siehe Fig. 1, von der Übergabestelle 22 weg oder zu dieser hin bewegt, muss das Hubband 44 angehoben oder abgesenkt werden, um die Bewegungsbahn der Substratauflage 32 freizugeben. Auf diese Weise kann ein sehr geringer Spalt zwischen dem Hubband 44 und dem Endlosband 64 der Substratauflage 32 realisiert werden, so dass eine sehr materialschonende und positionsgenaue Übergabe von dem Hubband 44 auf das Endlosband 64 der Substratauflage 32 möglich ist. In analoger Weise wird das Hubband 46 angehoben oder abgesenkt, wenn die Substratauflage 38, siehe Fig. 1, in Richtung auf die Übergabestelle 22 oder von dieser weg bewegt wird. Auch zwischen dem Hubband 46 und der Substratauflage 32 kann dadurch ein sehr kleiner Übergabespalt realisiert werden.

Im Betrieb der Siebdruckstation wird auf dem Hubband 44 ein unbedruckter Solarzellenwafer zugefördert. Der auf dem Drucknest, der Substratauflage 32, befindliche Solarzellenwafer 50 ist in der Siebdruckstation 12 bedruckt worden und soll über das Hubband 46 abtransportiert werden. Mittels des Endlosbandes 64 kann gleichzeitig der unbedruckte Solarzellenwafer vom Hubband 44 übernommen und der bedruckte Solarzellenwafer 50 auf das Hubband 46 übergeben werden. Dadurch können kurze Taktzeiten realisiert werden

Die Substratauflage 32 kann weiter mit einer Reinigungseinrichtung 72 für das umlaufende Endlosband 64 sowie mit Kontrolleinrichtungen zur Überprüfung des Endlosbandes versehen sein. Beispielsweise kann mittels einer weiteren Kamera 74 während der Übernahme und/oder der Übergabe eines Solarzellenwafers 50 das Endlosband 64 auf Beschädigungen und Verunreinigungen kontrolliert werden.

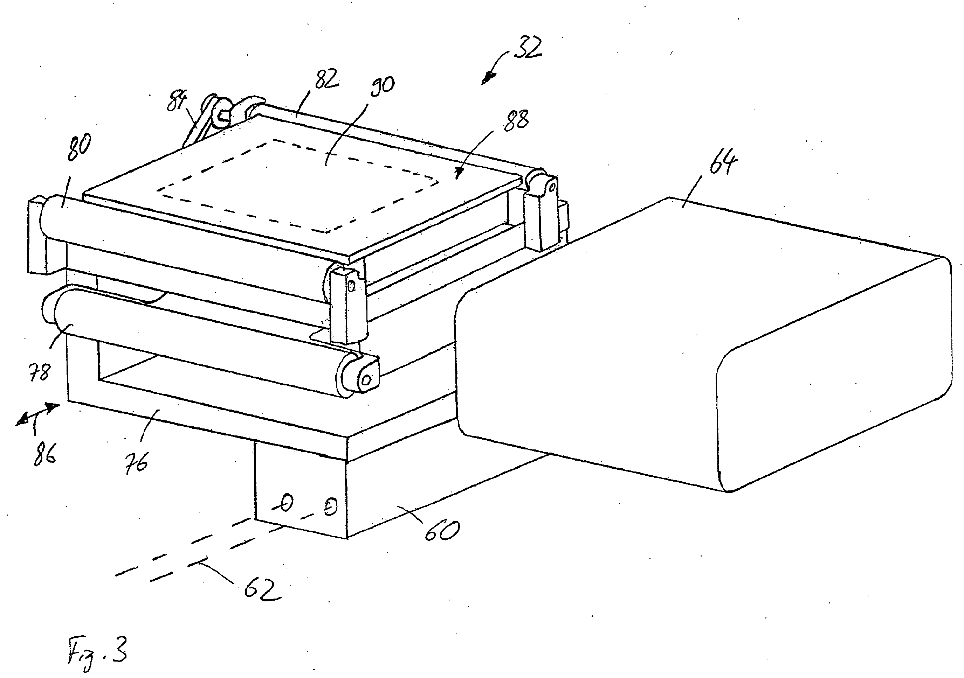

Die Darstellung der Fig. 3 zeigt die Substratauflage 32 der Fig. 2 in einer weiteren schematischen Ansicht von schräg oben. Die Substratauflage 32 ist als Drucknest ausgebildet und es ist zu erkennen, dass die Substratauflage 32 frei auskragend auf einem Tragrahmen 76 angeordnet ist, der wiederum an dem Schlitten 60 befestigt ist, der auf den Längsführungen 62 verschiebbar angeordnet ist. Dadurch, dass die Substratauflage 32 frei auskragend an dem Rahmen 76 angeordnet ist, kann das Endlosband 64 in einfacher Weise über die Substratauflage 32 geschoben und dadurch montiert bzw. gewechselt werden.

Das Endlosband 64 wird mittels vier Rollen 78, 80, 82, von denen lediglich drei erkennbar sind, um die Substratauflage 32 herumgeführt. Die Rolle 82 ist dabei mittels eines Riemens 84, beispielsweise eines Zahnriemens und über ein nicht dargestellten Antrieb angetrieben.

Die Rolle 78 ist als Spannrolle ausgebildet und ist relativ zur Substratauflage 32 in den Richtungen des Doppelpfeiles 68 verschiebbar. Das Endlosband 64 kann mittels der Spannrolle 78 dadurch gespannt oder gelockert werden. Zum Wechseln des Endlosbandes 64 wird die Spannrolle 78 nach innen, in der Fig. 3 also nach rechts oben, in Richtung auf die Substratauflage 32 zu bewegt. Dadurch lockert sich das Endlosband 64 und dieses kann nun in einfacher Weise von der Substratauflage 32 abgezogen werden. Das Endlosband 64 kann in einfacher Weise auch wieder auf die Substratauflage 32 aufgeschoben werden. Durch Bewegen der Rolle 78 von der Substratauflage 32 weg, in der Darstellung der Fig. 3 also nach links unten, wird das Endlosband 64 dann wieder gespannt. Die spezielle, auskragende Ausbildung bzw. Anordnung der Substratauflage 32 erleichtert dadurch den Wechsel des Endlosbandes 64 erheblich.

Das Endlosband 64 ist über eine Auflageplatte 88 geführt, die transparent ausgebildet ist und die in einem gestrichelt angedeuteten Bereich 90 mit Durchgangsbohrungen versehen ist. In dem Bereich 90 kann dadurch ein Unterdruck angelegt werden, wie anhand der Fig. 2 erläutert wurde. Da das Endlosband 64 durchsaugbar ausgebildet ist, kann dadurch ein auf dem Endlosband 64 aufliegender Solarzellenwafer zusammen mit diesem gegen die Auflageplatte 88 gesaugt und dadurch unverrückbar festgehalten werden. Die transparente Ausbildung der Auflageplatte 88 ermöglicht in Kombination mit der durchleuchtbaren Ausbildung des Endlosbandes 64 die Überprüfung eines auf dem Endlosband 64 aufliegenden Solarzellenwafers 50 im Durchlicht. Die Begriffe transparent und durchleuchtbar sind dabei so zu verstehen, dass sie auch eine Durchlässigkeit für elektromagnetische Strahlung außerhalb des sichtbaren Bereiches einschließen.

In der Darstellung der Fig. 2 ist eine weitere Überprüfungskamera 74 zu erkennen, die zur Überprüfung des Endlosbandes 64 vorgesehen ist. Mittels der Kamera 74 und geeigneter, nachgeschalteter Bilderkennungssoftware können Beschädigungen und Verunreinigungen des Endlosbandes 64 erkannt werden. Wird eine Verschmutzung des Endlosbandes 64 erkannt, so kann mittels einer zentralen Steuerung zunächst versucht werden, das Endlosband 64 mit der Reinigungseinrichtung 72 zu reinigen. Gelingt die Reinigung nicht, wie anhand einer weiteren Überprüfung mit der Überprüfungskamera 74 festgestellt werden kann, bewegt die Steuerung das Endlosband 64 so, dass der verschmutzte Bereich oben auf der Substratauflage 32 zu liegen kommt, also oberhalb der Auflageplatte 88. In dieser Position kann das Endlosband 64 dann in einfacher Weise von einem Bediener gereinigt werden.

Gelingt die Reinigung nicht, muss das Endlosband 64 ausgewechselt werden, wozu dann, wie erörtert wurde, die Spannrolle 78 nach innen gefahren wird, um das Endlosband 64 zu lockern und damit freizugeben.

## Patentansprüche

1. Bearbeitungsstation für flächige Substrate mit wenigstens zwei Bearbeitungseinheiten (12, 14) und wenigstens zwei parallel zueinander angeordneten Transportlinien (16, 18) für Substrate, wobei die beiden Bearbeitungseinheiten (12, 14) zwischen den beiden Transportlinien (16, 18) platziert sind, sowie Mitteln zum Bewegen der Substrate von den Transportlinien (16, 18) zu den Bearbeitungseinheiten (12, 14) und zurück, wobei die Mittel zum Bewegen der Substrate vier Lineartransporteinheiten (24, 26, 28, 30) mit jeweils wenigstens einer Substratauflage (32, 34, 36, 38) aufweisen, **dadurch gekennzeichnet, dass** eine erste Lineartransporteinheit (24) zwischen einer Übergabestelle (22) in der zweiten Transportlinie (18) und der ersten Bearbeitungseinheit (12) angeordnet ist, eine zweite Lineartransporteinheit (26) zwischen einer Übergabestelle (20) in der ersten Transportlinie (16) und der ersten Bearbeitungseinheit (12) angeordnet ist, eine dritte Lineartransporteinheit (26) zwischen einer Übergabestelle (20) in der ersten Transportlinie (16) und der zweiten Bearbeitungseinheit (14) angeordnet ist und eine vierte Lineartransporteinheit (30) zwischen einer Übergabestelle (22) in der zweiten Transportlinie (18) und der zweiten Bearbeitungseinheit (14) angeordnet ist.

2. Bearbeitungsstation nach Anspruch 1, **dadurch gekennzeichnet, dass** die erste und die vierte Lineartransporteinheit (24, 30) ausgebildet sind, die jeweilige Substratauflage (32, 38) an eine gemeinsame Übergabestelle (22) im Bereich der zweiten Transportlinie (18) zu bewegen.

3. Bearbeitungsstation nach Anspruch 1 oder 2, **dadurch gekennzeichnet, dass** die zweite und die dritte Lineartransporteinheit (26, 28) ausgebildet sind, die jeweilige Substratauflage (32, 38) an eine gemeinsame Übergabestelle (20) im Bereich der ersten Transportlinie (16) zu bewegen.

4. Bearbeitungsstation nach wenigstens einem der vorstehenden Ansprüche, **dadurch gekennzeichnet, dass** die beiden Bearbeitungseinheiten (12, 14) in Transportrichtung der Transportlinien (16, 18) voneinander beabstandet angeordnet sind und dass die vier Lineartransporteinheiten (24, 26, 28, 30) in der Draufsicht eine rautenartige Anordnung bilden.

5. Bearbeitungsstation nach wenigstens einem der vorstehenden Ansprüche, **dadurch gekennzeichnet, dass** die Lineartransporteinheiten (24, 26, 28, 30) als Linearführungen (62) mit darauf geführtem Schlitten (60), sogenannte Linearachsen, ausgebildet sind.

6. Bearbeitungsstation nach wenigstens einem der vorstehenden Ansprüche, **dadurch gekennzeichnet, dass** die erste und die zweite Transportlinie (16, 18) im Bereich der jeweiligen Übergabestelle (20, 22) an die Lineartransporteinheiten (24, 26, 28, 30) abschnittsweise aus einer Bewegungsbahn der Substratauflagen (32, 34, 36, 38) der Lineartransporteinheiten (24, 26, 28, 30) herausbewegbar sind.

7. Bearbeitungsstation nach Anspruch 6, **dadurch gekennzeichnet, dass** die erste und die zweite Transportlinie (16, 18) im Bereich der jeweiligen Übergabestelle (20, 22) Hubbänder (40, 42, 44, 46), Klappbänder, Schwenkbänder und/oder Teleskopbänder aufweisen.

8. Bearbeitungsstation nach wenigstens einem der vorstehenden Ansprüche, **dadurch gekennzeichnet, dass** die Bearbeitungseinheiten (12, 14) als Siebdruckstationen und die Substratauflagen (32, 34, 36, 38) als Drucknester ausgebildet sind.

9. Bearbeitungsstation nach wenigstens einem der vorstehenden Ansprüche, **dadurch gekennzeichnet, dass** die Substratauflagen mit einem über die Auflagefläche führenden Band versehen sind.

10. Bearbeitungsstation nach Anspruch 9, **dadurch gekennzeichnet, dass** Einrichtungen zum Bewegen des Bands in zwei einander entgegen gesetzte Richtungen über die Auflagefläche vorgesehen sind.

11. Bearbeitungsstation nach wenigstens einem der vorstehenden Ansprüche, **dadurch gekennzeichnet, dass** die Substratauflagen (32, 34, 36, 38) mit einem über die Auflagefläche führenden Endlosband (64) versehen sind.

12. Bearbeitungsstation nach Anspruch 11, **dadurch gekennzeichnet, dass** das Endlosband (64) durchleuchtbar und/oder durchsaugbar ausgebildet ist.

13. Verfahren zum Bearbeiten von flächigen Substraten mit einer Bearbeitungsstation (10) nach einem der vorstehenden Ansprüche, **gekennzeichnet durch** Bewegen von unbearbeiteten Substraten mittels einer der Lineartransporteinheiten (24, 26, 28, 30) von einer der Übergabestellen (20, 22) der Transportlinien (16, 18) zu einer Bearbeitungseinheit (12, 14) und Rücktransport des bearbeiteten Substrats von der Bearbeitungseinheit (12, 14) zu derselben Übergabestelle (20, 22) der Transportlinien (16, 18) mittels derselben Lineartransporteinheit (24, 26, 28, 30).

14. Verfahren nach Anspruch 13, **gekennzeichnet durch** folgende, im wesentlichen gleichzeite Transportbewegungen: Bewegen eines ersten Substrats mittels der ersten Lineartransporteinheit (24) von der zweiten Transportlinie (18) zu der ersten Bearbeitungseinheit und Bewegen eines zweiten Substrats mittels der zweiten Lineartransporteinheit (26) von der ersten Bearbeitungseinheit (12) zu der ersten Transportlinie (16).

15. Verfahren nach Anspruch 13 oder 14, **gekennzeichnet durch** folgende, im wesentlichen gleichzeitige Transportbewegungen: Bewegen eines dritten Substrats mittels der dritten Lineartransporteinheit (28) von der ersten Transportlinie (16) zu der zweiten Bearbeitungseinheit (14) und Bewegen eines vierten Substrats mittels der vierten Lineartransporteinheit (30) von der zweiten Bearbeitungseinheit (14) zu der zweiten Transportlinie (18).

16. Verfahren nach wenigstens einem der vorstehenden Ansprüche 12 bis 14, **gekennzeichnet durch** Übergeben von Substraten von den Transportlinien (16, 18) zu den Substratauflagen (32, 34, 36, 38) der Lineartransporteinheiten (24, 26, 28, 30) und umgekehrt im Bereich von Übergabestellen (20, 22) und abschnittsweises Bewegen der Transportlinien (16, 18) im Bereich der Übergabestellen (20, 22) zum Freigeben einer Bewegungsbahn der Substratauflagen (32, 34, 36, 38).

17. Verfahren nach Anspruch 16, **gekennzeichnet durch** Bewegen von Hubbändern (40, 42, 44, 46), Klappbändern, Schwenkbändern und/oder Teleskopbändern der Transportlinien (16, 18) zum Freigeben der Bewegungsbahn der Substratauflagen (32, 34, 36, 38).

## Claims

1. A processing station for two-dimensional substrates including at least two processing units (12, 14) and at least two conveyor lines (16, 18) for substrates arranged in parallel to another, wherein both the processing units (12, 14) are placed between the two conveyor lines (16, 18), and means for moving the substrates from the conveyor lines (16, 18) to the processing units (12, 14) and back, wherein the means for moving the substrates include four linear conveyor units (24, 26, 28, 30) each having at least one substrate support (32, 34, 36, 38), **characterized in that** a first linear conveyor unit (24) is disposed between a transfer point (22) in the second conveyor line (18) and the first processing unit (12), a second linear conveyor unit (26) is disposed between a transfer point (20) in the first conveyor line (16) and the first processing unit (12), a third linear conveyor unit (26) is disposed between a transfer point (20) in the first conveyor line (16) and the second processing unit (14), and a fourth linear conveyor unit (30) is disposed between a transfer point (22) in the second conveyor line (18) and the second processing unit (14).

2. The processing station according to claim 1, **characterized in that** the first and the fourth linear conveyor units (24, 30) are configured to move the respective substrate support (32, 38) to a common transfer point (22) in the vicinity of the second conveyor line (18).

3. The processing station according to claim 1 or 2, **characterized in that** the second and the third linear conveyor units (26, 28) are configured to move the respective substrate support (32, 38) to a common transfer point (20) in the vicinity of the first conveyor line (16).

4. The processing station according to at least one of the preceding claims, **characterized in that** both the processing units (12, 14) are spaced one from the other in the advancement direction of the conveyor lines (16, 18) and **in that** the four linear conveyor units (24, 26, 28, 30) are in a diamond-type arrangement, as seen from above.

5. The processing station according to at least one of the preceding claims, **characterized in that** the linear conveyor units (24, 26, 28, 30) are linear guides (62), so-called linear axes, with slides (60) guided thereon.

6. The processing station according to at least one of the preceding claims, **characterized in that** the first and the second conveyor lines (16, 18) in the vicinity of a respective transfer point (20, 22) to the linear conveyor units (24, 26, 28, 30) are adapted to be sectionally moved out of a trajectory of the substrate supports (32, 34, 36, 38) of the linear conveyor units (24, 26, 28, 30).

7. The processing station according to claim 6, **characterized in that** the first and the second conveyor lines (16, 18) in the vicinity of a respective transfer point (20, 22) include lift belts (40, 42, 44, 46), folding belts, slewing belts, and/or telescopic belts.

8. The processing station according to at least one of the preceding claims, **characterized in that** the processing units (12, 14) are screen printing stations and the substrate supports (32, 34, 36, 38) are print nests.

9. The processing station according to at least one of the preceding claims, **characterized in that** the substrate supports are provided with a belt passing over the support surface.

10. The processing station according to claim 9, **characterized in that** devices are provided for moving the belt over the support surface in two opposed directions.

11. The processing station according to at least one of the preceding claims, **characterized in that** the substrate supports (32, 34, 36, 38) are provided with an endless belt (64) passing over the support surface.

12. The processing station according to claim 11, **characterized in that** the endless belt (64) is adapted to be transmitting radiation and/or adapted to be sucked through.

13. A method for processing two-dimensional substrates using a processing station (10) according to any of the preceding claims, **characterized by** moving unprocessed substrates by means of one of the linear conveyor units (24, 26, 28, 30) from one of the transfer points (20, 22) of the conveyor lines (16, 18) to a processing unit (12, 14) and return of the processed substrate from the processing unit (12, 14) to the same transfer point (20, 22) of the conveyor lines (16, 18) by means of the same linear conveyor unit (24, 26, 28, 30).

14. The method according to claim 13, **characterized by** the following, essentially simultaneous conveying movements: moving of a first substrate by means of the first linear conveyor unit (24) from the second conveyor line (18) to the first processing unit (12) and moving of a second substrate by means of the second linear conveyor unit (26) from the first processing unit (12) to the first conveyor line (16).

15. The method according to claim 13 or 14, **characterized by** the following, essentially simultaneous conveying movements: moving of a third substrate by means of the third linear conveyor unit (28) from the first conveyor line (16) to the second processing unit (14) and moving of a fourth substrate by means of the fourth linear conveyor unit (30) from the second processing unit (14) to the second conveyor line (18).

16. The method according to at least one of the preceding claims 12 to 14, **characterized by** transferring of substrates from the conveyor lines (16, 18) to the substrate supports (32, 34, 36, 38) of the linear conveyor units (24, 26, 28, 30) and reverse in the vicinity of transfer points (20, 22) and sectional moving of the conveyor lines (16, 18) in the vicinity of the transfer points (20, 22) to clear a trajectory of the substrate supports (32, 34, 36, 38).

17. The method according to claim 16, **characterized by** moving of lift belts (40, 42, 44, 46), folding belts, slewing belts, and/or telescopic belts of the conveyor lines (16, 18) to clear the trajectory of the substrate supports (32, 34, 36, 38).

## Revendications

1. Station de traitement de substrats plans comprenant au moins deux unités de traitement (12, 14) et au moins deux lignes de transport (16, 18) de substrats disposées parallèlement les unes aux autres, les deux unités de traitement (12, 14) étant placées entre les deux lignes de transport (16, 18), ainsi que des moyens pour déplacer les substrats depuis les lignes de transport (16, 18) jusqu'aux unités de traitement (12, 14) et inversement, les moyens pour déplacer les substrats présentant quatre unités de transport linéaires (24, 26, 28, 30) ayant chacune au moins un support de substrat (32, 34, 36, 38), **caractérisée en ce qu'**une première unité de transport linéaire (24) est disposée entre une zone de transfert (22) dans la deuxième ligne de transport (18) et la première unité de traitement (12), une deuxième unité de transport linéaire (26) est disposée entre une zone de transfert (20) dans la première ligne de transport (16) et la première unité de traitement (12), une troisième unité de transport linéaire (26) est disposée entre une zone de transfert (20) dans la première ligne de transport (16) et la deuxième unité de traitement (14) et une quatrième unité de transport linéaire (30) est disposée entre une zone de transfert (22) dans la deuxième ligne de transport (18) et la deuxième unité de traitement (14).

2. Station de traitement selon la revendication 1, **caractérisée en ce que** la première et la quatrième unité de transport linéaire (24, 30) sont réalisées de manière à déplacer le support de substrat respectif (32, 38) à une zone de transfert commune (22) dans la région de la deuxième ligne de transport (18).

3. Station de traitement selon la revendication 1 ou 2, **caractérisée en ce que** la deuxième et la troisième unité de transport linéaire (26, 28) sont réalisées de manière à déplacer le support de substrat respectif (32, 38) à une zone de transfert commune (20) dans la région de la première ligne de transport (16).

4. Station de traitement selon au moins l'une quelconque des revendications précédentes, **caractérisée en ce que** les deux unités de traitement (12, 14) sont disposées de manière espacée l'une de l'autre dans la direction de transport des lignes de transport (16, 18) et **en ce que** les quatre unités de transport linéaires (24, 26, 28, 30) forment en vue de dessus un agencement en forme de losange.

5. Station de traitement selon au moins l'une quelconque des revendications précédentes, **caractérisée en ce que** les unités de transport linéaires (24, 26, 28, 30) sont réalisées sous forme de guides linéaires (62) que l'on appelle des axes linéaires, avec un chariot (60) guidé sur ceux-ci.

6. Station de traitement selon au moins l'une quelconque des revendications précédentes, **caractérisée en ce que** la première et la deuxième ligne de transport (16, 18) dans la région de la zone de transfert respective (20, 22) aux unités de transport linéaires (24, 26, 28, 30) peuvent être déplacées par sections hors d'une voie de déplacement des supports de substrats (32, 34, 36, 38) des unités de transport linéaires (24, 26, 28, 30).

7. Station de traitement selon la revendication 6, **caractérisée en ce que** la première et la deuxième ligne de transport (16, 18) présentent, dans la région de la zone de transfert respective (20, 22), des bandes de levage (40, 42, 44, 46), des bandes de rabattement, des bandes de pivotement et/ou des bandes de télescopage.

8. Station de traitement selon au moins l'une quelconque des revendications précédentes, **caractérisée en ce que** les unités de traitement (12, 14) sont réalisées sous forme de stations de sérigraphie et les supports de substrats (32, 34, 36, 38) sont réalisés sous forme de nids d'impression.

9. Station de traitement selon au moins l'une quelconque des revendications précédentes, **caractérisée en ce que** les supports de substrats sont pourvus d'une bande passant sur la surface de support.

10. Station de traitement selon la revendication 9, **caractérisée en ce que** des dispositifs sont prévus pour déplacer la bande dans deux directions opposées l'une à l'autre sur la surface de support.

11. Station de traitement selon au moins l'une quelconque des revendications précédentes, **caractérisée en ce que** les supports de substrats (32, 34, 36, 38) sont pourvus d'une bande sans fin (64) passant sur la surface de support.

12. Station de traitement selon la revendication 11, **caractérisée en ce que** la bande sans fin (64) est réalisée de manière à ce qu'on puisse éclairer et/ou aspirer à travers elle.

13. Procédé de traitement de substrats plans comprenant une station de traitement (10) selon l'une quelconque des revendications précédentes, **caractérisé par** le déplacement de substrats non traités au moyen de l'une des unités de transport linéaires (24, 26, 28, 30) depuis l'une des zones de transfert (20, 22) des lignes de transport (16, 18) jusqu'à une unité de traitement (12, 14) et par le transport en retour du substrat traité depuis l'unité de traitement (12, 14) jusqu'à la même zone de transfert (20, 22) des lignes de transport (16, 18) au moyen de la même unité de transport linéaire (24, 26, 28, 30).

14. Procédé selon la revendication 13, **caractérisé par** les déplacements de transport essentiellement simultanés suivants : déplacement d'un premier substrat au moyen de la première unité de transport linéaire (24) depuis la deuxième ligne de transport (18) jusqu'à la première unité de traitement (12) et déplacement d'un deuxième substrat au moyen de la deuxième unité de transport linéaire (26) depuis la première unité de traitement (12) jusqu'à la première ligne de transport (16).

15. Procédé selon la revendication 13 ou 14, **caractérisé par** les déplacements de transport essentiellement simultanés suivants : déplacement d'un troisième substrat au moyen de la troisième unité de transport linéaire (28) depuis la première ligne de transport (16) jusqu'à la deuxième unité de traitement (14) et déplacement d'un quatrième substrat au moyen de la quatrième unité de transport linéaire (30) de la deuxième unité de traitement (14) jusqu'à la deuxième ligne de transport (18).

16. Procédé selon au moins l'une quelconque des revendications précédentes 12 à 14, **caractérisé par** le transfert de substrats depuis les lignes de transport (16, 18) jusqu'aux supports de substrats (32, 34, 36, 38) des unités de transport linéaires (24, 26, 28, 30) et inversement dans la région de zones de transfert (20, 22) et déplacement par sections des lignes de transport (16, 18) dans la région des zones de transfert (20, 22) pour libérer une voie de déplacement des supports de substrats (32, 34, 36, 38).

17. Procédé selon la revendication 16, **caractérisé par** le déplacement de bandes de levage (40, 42, 44, 46), de bandes de rabattement, de bandes de pivotement et/ou de bandes de télescopage des lignes de transport (16, 18) pour libérer la voie de déplacement des supports de substrats (32, 34, 36, 38).
